# EUROPÄISCHE PATENTANMELDUNG

(11) **EP 1 414 060 A2**
(43) Veröffentlichungstag der Anmeldung: **28.04.2004**
(21) Anmeldenummer: 03024416.4
(22) Anmeldetag: 23.10.2003
(51) Int. Cl.: H01L 21/00

(54) **Einrichtung zur Detektion von übereinander mit einem bestimmten Abstand angeordneten Substraten**

(30) Priorität: 25.10.2002 DE 10250353
(71) Anmelder: Brooks-PRI Automation (Germany) GmbH, 07745 Jena (DE)
(72) Erfinder: Gilchrist, Ulysses, Massachusetts 01867 (US); Barriss, Louise S., North Reading Massachusetts 01864 (US); Raue, Hagen, 02633 Göda (DE); Lahne, Berndt, 07751 Rothenstein (DE); Heinze, Manfred, 01109 Dresden (DE); König, Joachim, 01728 Bannewitz (DE); Schultz, Klaus, 07745 Jena (DE)
(74) Vertreter: Bertram, Helmut

(57) **Zusammenfassung**

Bei einer Einrichtung zur Detektion von übereinander angeordneten Substraten an einer Öffnung eines Wandelementes besteht die Aufgabe, die Nachweiseinrichtung derart auszubilden, dass die Lageerfassung der Substrate hinsichtlich des Messablaufes und der angewendeten Messmethode flexibler ausgeführt werden kann und eine definierte Heranführung eines Sensorsystems in eine sichere Messposition an das zu detektierende Substrat bei einem verringerten Risiko einer Partikelgenerierung gewährleistet ist.

Eine Sende- und Empfangseinrichtung (11) besteht aus einem, an dem Wandelement (1) befestigten Vertikalantrieb (10) und einem, zwischen einer unteren und einer oberen Position durch den Vertikalantrieb (10) verstellbaren Sensorkopf (13), der zum Einschwenken in die Öffnung (4) an dem Vertikalantrieb (10) drehbar gelagert ist.

Die Einrichtung findet insbesondere Anwendung in der Halbleiterindustrie zur Erfassung des Bestückungszustandes von Kassetten oder Behältern mit Substraten, wie Halbleiterwafer, Flachschirmanzeigen oder Masken.

## Beschreibung

Die Erfindung bezieht sich auf eine Einrichtung zur Detektion von übereinander mit einem bestimmten Abstand angeordneten Substraten an einer Öffnung eines Wandelementes mit einem Verschluss für die Öffnung, der durch einen unterhalb der Öffnung positionierten Antrieb in wenigsten zwei unterschiedlichen Richtungen relativ zu dem Wandelement verstellbar ist und mit einer Sendeund Empfangseinrichtung zum Aussenden und Empfangen eines horizontal gerichteten Messstrahls.

Bei der Bearbeitung von Substraten, wie Halbleiterwafer, Flachschirmanzeigen oder Masken werden diese in der Regel einzeln in Fächern eines Behälters untergebracht, um sie mit automatischen Ausrüstungen handhaben zu können. Auf Grund der großen Anzahl von technologischen Schritten macht es sich wegen des damit verbundenen hohen Kostenaufwandes erforderlich, Schäden, die durch Fehler bei der Handhabung der Substrate entstehen können und zu deren Unbrauchbarkeit führen, zu vermeiden bzw. auf ein Minimum zu beschränken.

Aus diesem Grund wird vor der Entnahme der Substrate aus dem Behälter üblicherweise eine Anwesenheits- und Belegungskontrolle, ein sogenanntes Mapping durchgeführt, das dem Erkennen insbesondere von leeren Behälterfächern, der Doppelbelegung eines Behälterfaches oder Schräglagen der Substrate über zwei oder mehr Behälterfächer dient. Außerdem kann das Handhabungssystem durch genaue Kenntnis der tatsächlichen Positionen der Substrate effektiver arbeiten und Leerlaufroutinen vermeiden.
Bekannte Nachweiseinrichtungen arbeiten als feststehende optische Systeme oder als bewegliche Systeme auf Lichtschrankenbasis.

Ein bekanntes feststehendes optisches System nach der US 6 147 356 ist derart aufgebaut, dass mindestens zwei linear ausgedehnte Lichtquellenreihen parallel zu einer von den Behälterfächern und Substraten vorgegebenen Ebenenschar angeordnet sind und in einer Fläche parallel zu den zu detektierenden Kantenbereichen liegen. Zwischen den parallel angebrachten Lichtquellenreihen ist ein Objektiv angeordnet, mit dem eine Vielzahl von Behälterfächern gleichzeitig auf ein Sensorarray abgebildet wird, aus dem mindestens Anteile eines transversal soweit ausgedehnten Kantenbereiches des Substrates auslesbar sind, dass eine im Kantenbereich vorhandene Unregelmäßigkeit bei ihrer Abbildung auf das Sensorarray stets kleiner als die ausgelesenen Anteile des Kantenbereiches ist.
Zwar gestattet diese Lösung den Nachweis der Substrate unabhängig von deren Ausrichtung und von Unstetigkeiten in deren Randbereich, doch bleibt der allgemeine Nachteil feststehender optischer Systeme erhalten, dass eine ausreichende Reflektivität im Randbereich grundsätzlich vorhanden sein muss.

Diesen Nachteil können die auf Lichtschrankenbasis arbeitenden Sensorsysteme beheben, wie z. B. eine Einrichtung gemäß der US 6 188 323 B1, bei der das Sensorsystem mit einer für die Be- und Entladeöffnung vorgesehenen Tür verbunden ist. Das Sensorsystem, bei dem Sender und Empfänger gegenüberliegend und einander zugewandt angeordnet, an umklappbaren Hebeln befestigt sind, detektiert die Anwesenheit der Substrate im Behälter während des Absenkens der Tür. Dazu klappen die Hebel zu Beginn des Öffnungsvorganges in Richtung der Substrate aus und nach Beendigung des Öffnungs- und Messvorganges wieder ein. Zur Positionserkennung wird die Vertikalstellung des Türantriebes benutzt.

Durch die Anbindung des Erkennungsprozesses an den Bewegungsablauf der Tür werden zwar zusätzliche Verfahrensschritte vermieden, doch resultiert daraus wiederum eine Unflexibilität des Systems, da zwischenzeitliche Messungen ausgeschlossen sind bzw. zunächst den Schließvorgang der Tür erfordern. Außerdem ist die Lösung mit einem erhöhten Risiko der Partikelgenerierung verbunden, da Antriebselemente in Wafernähe gebracht werden und die großflächige Tür zu Verwirbelungen bei deren Bewegung führen kann.

Mit der Handhabungseinrichtung verbundene Sensorsysteme haben ebenfalls den Nachteil, weniger flexibel zu sein.

Ausgehend hiervon ist es Aufgabe der Erfindung, die Nachweiseinrichtung derart auszubilden, dass die Lageerfassung der Substrate hinsichtlich des Messablaufes und der angewendeten Messmethode flexibler ausgeführt werden kann und eine definierte Heranführung eines Sensorsystems an das zu detektierende Halbleitersubstrat in eine sichere Messposition bei einem verringerten Risiko einer Partikelgenerierung gewährleistet ist.

Diese Aufgabe wird bei einer Einrichtung der eingangs genannten Art dadurch gelöst, dass die Sende- und Empfangseinrichtung aus einem, an dem Wandelement befestigten Vertikalantrieb und einem, zwischen einer unteren und einer oberen Position durch den Vertikalantrieb verstellbaren Sensorkopf besteht, der zum Einschwenken in die Öffnung an dem Vertikalantrieb drehbar gelagert ist.

Die erfindungsgemäße Einrichtung gestattet eine höhere Flexibilität der Messabläufe zur Lageerfassung, da diese nicht mit einem Bewegungsablauf einer anderen Funktionseinheit verbunden sind, wie z. B. des Verschlusses beim Öffnen und Schließen der Öffnung in dem Wandelement oder eines Handhabungssystems, welches zur Entnahme und Rückführung der Substrate dient, jedoch nicht Bestandteil der erfindungsgemäßen Einrichtung ist.

Außerdem wirkt sich der Bewegungsablauf der Sende- und Empfangseinrichtung in keiner Weise störend auf die anderen Bewegungsabläufe aus, da der Vertikalantrieb unterhalb der Öffnung und außerhalb des Bewegungsbereiches des Verschlusses an dem Wandelement befestigt ist.

Der definierten Heranführung an die zu detektierenden Substrate dient auch eine vorteilhafte Ausgestaltung, bei der der Vertikalantrieb den Sensorkopf an einem Schwenkkopf mit horizontal gerichteter Schwenkachse trägt, der an einem vertikal ausfahrbaren Arm befestigt ist. Hierbei kann die Schwenkachse durch eine Hohlwelle verlaufen, auf der der Sensorkopf aufgesetzt ist und die zwischen zwei Endlagenpositionen verdrehbar ist.

Eine besondere Ausgestaltung der Erfindung sieht vor, dass der Sensorkopf als Gabellichtschranke ausgebildet ist, bei der an einem ersten Gabelende ein Sender zum Aussenden eines entlang eines Messstrahlenganges auf das andere Gabelende gerichteten Messstrahls angebracht und an dem anderen Gabelende eine Strahlumlenkeinrichtung vorgesehen ist, von der aus eine daran angekoppelte Lichtleitfaser außerhalb des Messstrahlenganges mittels einer Optik lichtdicht an einen Empfänger an dem ersten Gabelende geführt ist. Durch diese Gestaltung wird einerseits ermöglicht, dass Sender und Empfänger eine Einheit bilden und das freie Ende der Gabel nicht durch einen Empfänger belastet wird und das andererseits eine Beeinflussung durch Streu- und Fremdlicht ausgeschlossen wird.

Hierbei wird das bei der Vertikalbewegung des Sensorkopfes zwischen den beiden Gabelenden hindurchgeführte Messobjekt im Durchstrahlverfahren mit dem Empfänger aufgenommen und in einer Ansteuer- und Auswerteelektronik, die an den Empfänger angeschlossenen ist, ausgewertet.

Da der Vertikalantrieb als Motor-Spindel-Kombination aufgebaut ist, die zum Erkennen der vertikalen Positionen einen Encoder aufweist, der mit der Ansteuerund Auswerteelektronik der Sende- und Empfangseinrichtung verbunden ist, sind die aus dem Empfänger erhaltenen Messsignale den ermittelten Positionen zuzuordnen.

Die benachbarte Anordnung von Sender und Empfänger am selben Gabelende, die Strahlrückführung des Messstrahls über die Lichtleitfaser und deren lichtdichte Ankopplung an den Empfänger gewährleistet eine von Materialeigenschaften unabhängige Messwerterfassung. Es wird sichergestellt, dass nur der ausgesendete Messstrahl, der im Messstrahlengang von dem Messobjekt nicht zurückgehalten wird, auf den Empfänger gelangt. Fremdlichteinflüsse, die durch Beleuchtung, Spiegelungen und Reflexionen an den vorhandenen Oberflächen entstehen und einen Störeinfluss auf das Messsignal haben können, werden mit dem vorliegenden Sensorkopf, im Gegensatz zu den bekannten Messeinrichtungen, ausgeschlossen.

Außerdem zeichnet sich der Sensorkopf infolge der Strahlführung über die Lichtleitfaser durch einen sehr kleinen Bauraum und ein sehr geringes Gewicht aus, wodurch Schwingeffekte beim Heben und Schwenken erheblich reduziert sind.

Die drehbare Lagerung der Gabellichtschranke an dem Vertikalantrieb kann vorteilhaft derart ausgebildet sein, dass die horizontal gerichtete Schwenkachse parallel und beabstandet zum Messstrahlengang verläuft, so dass die Gabelenden bei einer Schwenkung um die Schwenkachse durch die Öffnung in dem Wandelement hindurchtreten. Auf diese Weise wird eine kompakte Einrichtung mit einem an die nachzuweisenden Substrate heranführbaren Messstrahlengang realisiert.

Besonders vorteilhaft wirkt es sich aus, wenn als Sender ein Laser mit einem lichtstarken Messstrahl und kleinem Öffnungswinkel dient, der präzise an die Dicke der Substrate angepasst werden kann.

Eine vorteilhafte Weiterbildung der Erfindung besteht darin, dass die Sende- und Empfangseinrichtung mit einer eigenen Ansteuer- und Auswerteelektronik versehen ist, die an ein Bussystem einer zentralen Logiksteuerung angeschlossen ist.

Die Sende- und Empfangseinrichtung, die durch ihre konstruktive Gestaltung besonders dazu geeignet ist, nachträglich in bestehende Be- und Entladestationen eingebaut zu werden, kann dadurch zu einem Bestandteil eines modularen Systems von Funktionseinheiten ausgebildet werden, bei denen jede Funktionseinheit mit einer eigenen Ansteuer- und Auswerteelektronik ausgestattet ist, die über das Bussystem an die zentrale Logiksteuerung angeschlossen ist. Die Ansteuer- und Auswerteelektronik der Sende- und Empfangseinrichtung sowie die der anderen Funktionseinheiten, wie z. B. des Verschlusses, können in einfacher Weise von dem Bussystem getrennt werden. Ebenso ist es möglich, weitere Funktionseinheiten hinzuzufügen oder einen Austausch vorzunehmen, wobei in jedem Fall die sofortige Funktionsfähigkeit gewährleistet ist.

Schließlich kann der Sensorkopf der Sende- und Empfangseinrichtung in einer weiteren, alternativen Ausgestaltung auch als Reflexmesseinrichtung ausgeführt sein, bei der Sender und Empfänger am Sensorkopf benachbart zueinander angeordnet sind. Der von dem Sender ausgesendete Messstrahl wird, anstatt im Durchstrahlverfahren, nach dessen Reflexion an dem nachzuweisenden Substrat mit dem Empfänger aufgenommen.

Die Erfindung soll nachstehend anhand der schematischen Zeichnung näher erläutert werden. Es zeigen:
- Fig. 1: eine Einrichtung zur Detektion von übereinander angeordneten Substraten mit einer in Parkposition befindlichen Sende- und Empfangseinrichtung
- Fig. 2: die Einrichtung gemäß Fig. 1, bei der sich die Sende- und Empfangseinrichtung in einer Arbeitsposition befindet
- Fig. 3: die Sende- und Empfangseinrichtung
- Fig. 4: einen Schwenkkopf zur Verstellung des Sensorkopfes von einer Ruheposition in eine Arbeitsposition
- Fig. 5: einen für die Sende- und Empfangseinrichtung vorgesehenen Sensorkopf in einer ersten Ansicht mit geöffnetem Sende- und Empfangsteil
- Fig. 6: den Sensorkopf in einer zweiten Ansicht

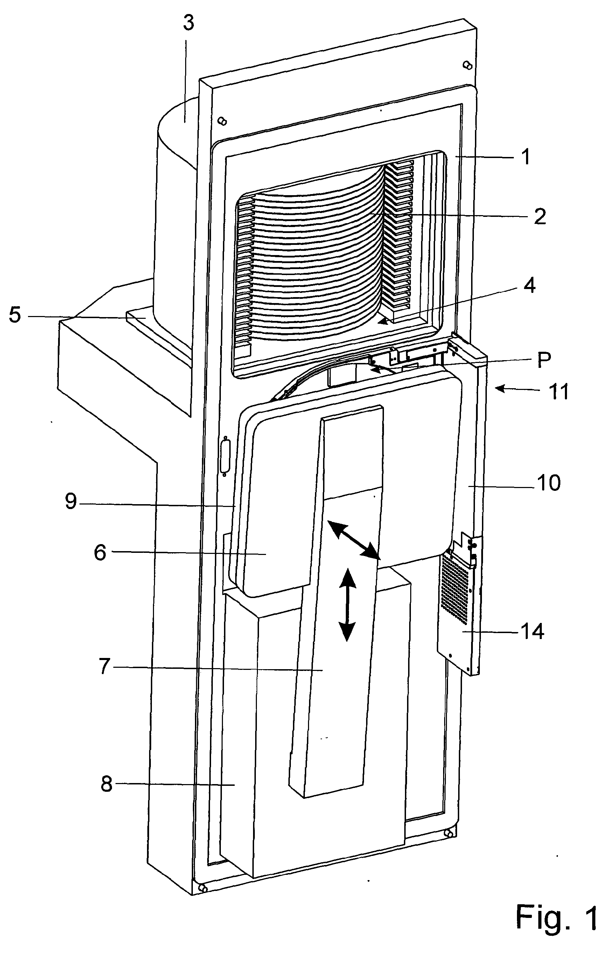

Bei der in Fig. 1 dargestellten Einrichtung ist in ein rahmenförmiges Wandelement 1 eine zum Be- und Entladen eines mit Halbleiterwafern 2 als Substrate bestückten Behälters 3 dienende Öffnung 4 eingearbeitet. Für die Positionierung des Behälters 3 an der Öffnung 4 wird dieser auf einer Plattform 5 abgestellt, so dass seine zu öffnende Seite mit der Öffnung 4 fluchtet. Ein in Offenstellung befindlicher Verschluss 6 ist an einem höhen- und gegen das Wandelement 1 verstellbaren Arm 7 befestigt, für den in einem Gehäuseteil 8 sowohl zur Höhenverstellung als auch zur Verstellung des Armes 7 gegen das Wandelement 1 Antriebsmittel, z. B. in Form von Hubzylindern vorgesehen sind. Zur Verstellung gegen das Wandelement 1 ist der Arm 7 außerdem im unteren Bereich um eine horizontale Achse schwenkbar. Der Verschluss 6 trägt eine bereits beim Öffnungsvorgang von der zu öffnenden Seite des Behälters 3 abgenommene Behältertür 9.

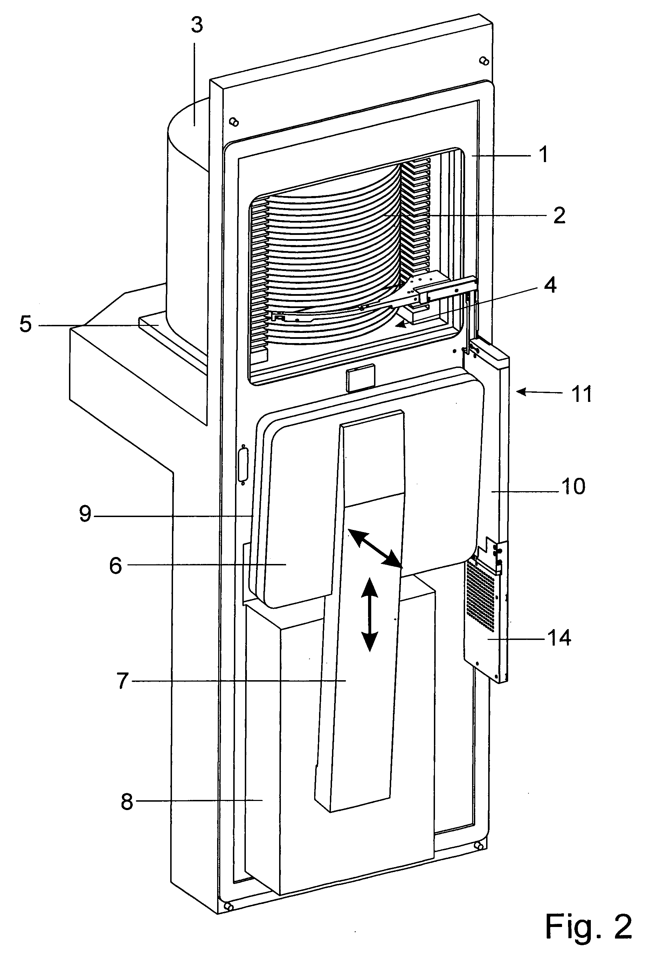

Unterhalb der Öffnung 4, seitlich benachbart zu dem Gehäuseteil 8 und den darin enthaltenen Antriebsmitteln für den Verschluss 6 und außerhalb des Bewegungsbereiches des Verschlusses 6 ist ein Vertikalantrieb 10 einer Sende- und Empfangseinrichtung 11 befestigt, der an einem, zwischen einer unteren und einer oberen Position verstellbaren Arm 12 einen Sensorkopf 13 trägt. In der Darstellung gemäß Fig. 1 befindet sich der Sensorkopf 13 in der als Ruhestellung dienenden unteren Position P und in Fig. 2 in einer zwischen der unteren und der oberen Position liegenden Arbeitsstellung, bei der der Sensorkopf 13 gegenüber der Ruhestellung durch eine 90°-Schwenkung definiert an die Halbleiterwafer 2 herangeführt ist und in die Öffnung 4 hineinragt.

An den Vertikalantrieb 10 baulich angekoppelt ist ein Gehäuseteil 14, in dem die für die Sende- und Empfangseinrichtung 11 erforderliche Ansteuer- und Auswerteelektronik untergebracht ist, welche in nicht dargestellter Weise an ein Bussystem einer zentralen Logiksteuerung angeschlossen ist.

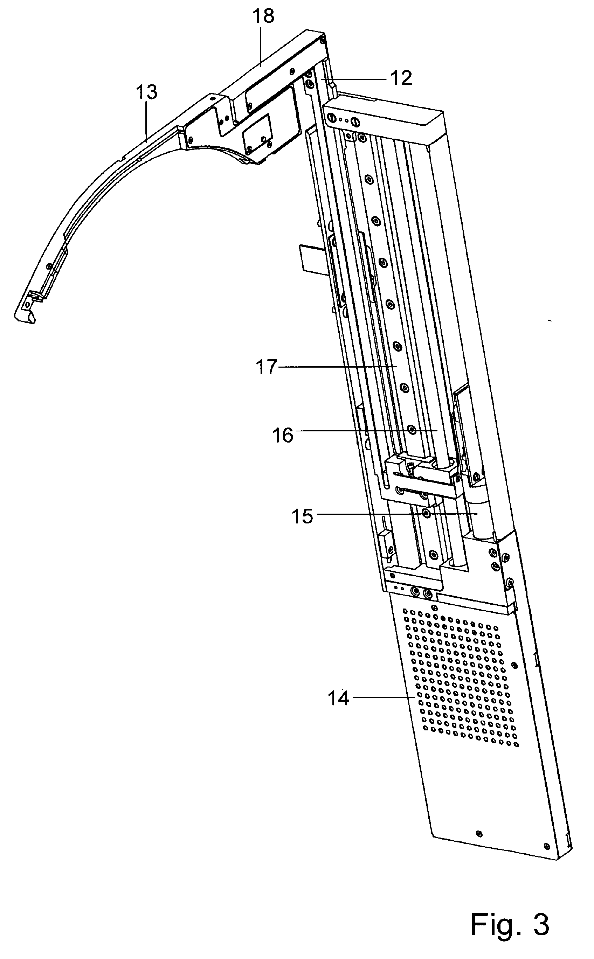

Die detaillierte Darstellung der Sende- und Empfangseinrichtung 11 gemäß Fig. 3 verdeutlicht den Vertikalantrieb 10, der einen, mit einem Encoder versehenen DC-Servo-Antriebsmotor 15 mit einer hohen Positionierungsgenauigkeit von weniger als 100 µm enthält, der über einen Zahnriementrieb eine Präzisionsspindel 16 antreibt. Das Spannen des Zahnriemens erfolgt durch eine exzentrische Motordrehung. An der Präzisionsspindel 16 ist über eine Präzisionslinearführung 17 der vertikal ausfahrbare Arm 12 aus hochsteifem Material zwangsfrei angekoppelt, der den als Gabellichtschranke ausgebildeten Sensorkopf 13 an einem abgewinkelten Schwenkkopf 18 trägt.

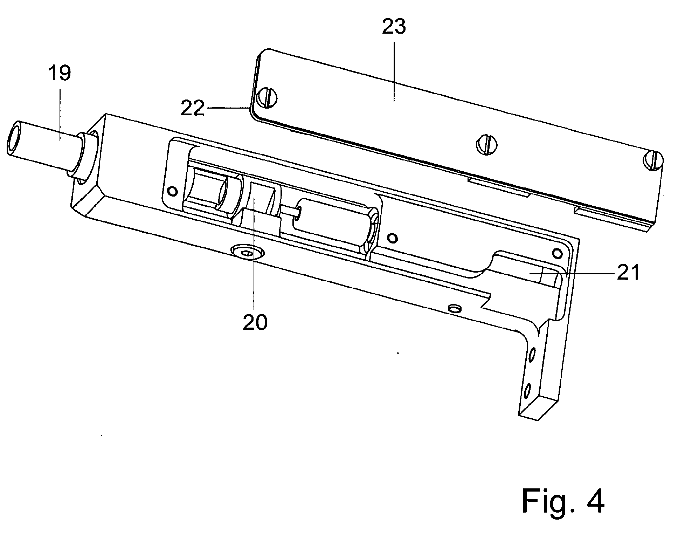

Der Schwenkkopf 18 enthält eine in Fig. 4 dargestellte Hohlwelle 19, auf der der Sensorkopf 13 zum Verschwenken zwischen den Stellungen der Ruheposition und der Arbeitsposition aufgesetzt ist. Die sich um 90° unterscheidenden Stellungen sind durch einen Endlagenanschlag 20 und ein elektrisch eingestelltes Haltemoment eines zum Antrieb der Hohlwelle 19 vorgesehenen DC-Antriebsmotors 21 gewährleistet und werden über ein Geschwindigkeitsprofil angefahren.
Zur Erkennung des Endlagenanschlages 20 sind (Hall-) Sensoren auf einer Leiterplatte 22 für die Sensorzuschaltung an einer Schließplatte 23 vorgesehen.

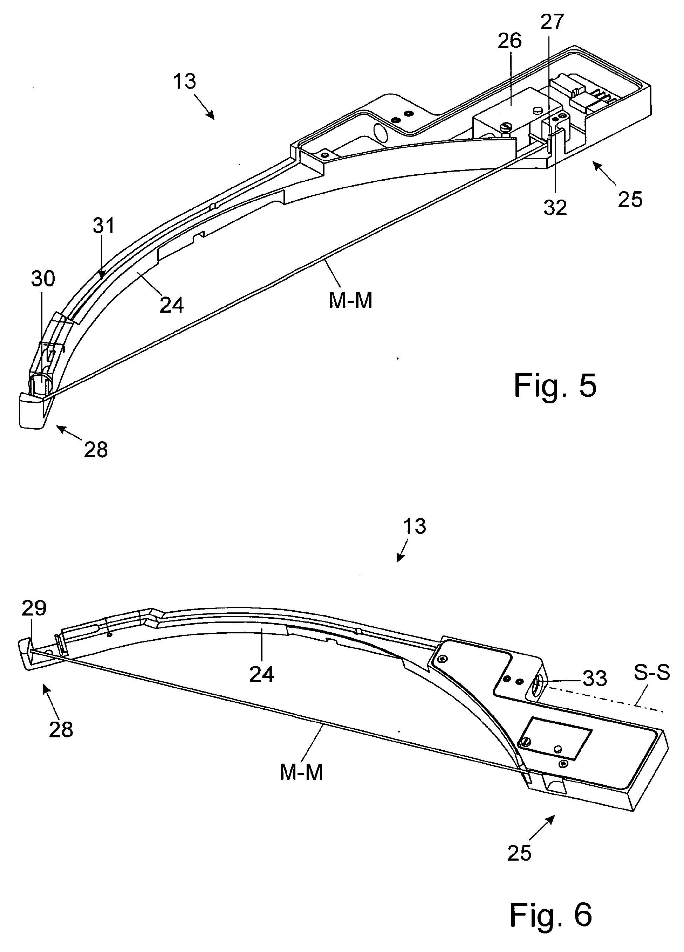

Der in den Figuren 5 und 6 dargestellte Sensorkopf 13 ist als gewichtsminimierte bogenförmige Gabel 24 ausgebildet, bei der an einem, als Sende- und Empfangsteil dienenden ersten Gabelende 25 ein Sender 26 in Form eines Lasers zum Aussenden eines Messstrahls angebracht ist, der zur Bauraumminimierung über einen ersten Umlenkspiegel 27 entlang eines Messstrahlenganges M-M auf das andere Gabelende 28 gerichtet ist. Ein an dem anderen Gabelende 28 in die Struktur der Gabel 24 eingearbeiteter zweiter Umlenkspiegel 29 koppelt den Messstrahl über eine Sammellinse 30 in eine Lichtleitfaser 31 ein, die außerhalb des Messstrahlenganges M-M in der Gabel 24 mittels einer hier verdeckten Optik lichtdicht an einen Empfänger 32 an dem ersten Gabelende 25 geführt ist. Der Lasersender 26 gewährleistet einen optimalen Fokus am Rand des Halbleiterwafers 2 und damit eine ausreichende Auflösung der Dicke des Halbleiterwafers 2.

Zum Aufsetzen des Sensorkopfes 13 auf die Hohlwelle 20 ist eine zum Messstrahlengang M-M mit Abstand benachbarte, parallel gerichtete Bohrung 33 vorgesehen, wodurch für den Sensorkopf 13 eine Schwenkachse S-S resultiert, so dass bei einer Schwenkung um die Schwenkachse S-S die Gabelenden 25 und 28 durch die Öffnung 4 in dem Wandelement 1 hindurchtreten.
Die Arbeitsweise mit der erfindungsgemäßen Einrichtung erfolgt in einer Weise, bei der eine Behinderung der Funktionen des Öffnens, eines Zugriffs einer Handhabungseinrichtung sowie weiterer, durch SEMI-Standards festgelegter Sensorelemente ausgeschlossen ist.

Nachdem der Öffnungsvorgang für die Öffnung 4 in dem Wandelement 1 abgeschlossen ist (Fig. 1 und 2), wofür der Verschluss 6 zuvor unter Mitnahme der Behältertür 9 eine erste, von dem Wandelement 1 weggerichtete Bewegung und anschließend eine zweite vertikale Bewegung nach unten ausgeführt hat, wird der Sensorkopf 13 aus der Parkposition P, mit dem Vertikalantrieb 10 soweit nach oben gefahren, dass die Gabelenden 25 und 28 durch Schwenken des Sensorkopfes 13 um die Schwenkachse S-S durch die Öffnung 4 hindurch definiert an die zu detektierenden Halbleiterwafer 2 in eine Arbeitsposition herangebracht werden können. Das Einschwenken geschieht in einer möglichst unteren Position, so dass das Partikel-Kontaminationsrisiko minimiert wird.

Danach wird der Sensorkopf 13 in die obere Position oberhalb der höchstmöglichen Position eines Halbleiterwafers 2 gefahren, der Sender 26 und der Empfänger 32 werden eingeschaltet und der Lichtschrankenbetrieb wird getestet. Anschließend wird der Sensorkopf 13 mit dem Vertikalantrieb 10 an allen möglichen Halbleiterwafern 2 vorbei nach unten gefahren und ohne Zwischenstop werden die Vertikalkoordinaten der Lichtschranken-Unterbrechungen zum Nachweis des Vorhandenseins und der Position der Halbleiterwafer 2 in dem Behälter 3 registriert. Die Vertikalbewegung nach unten ist bevorzugt, da hierbei Schwingungseffekte reduziert sind. Während sich das Vorhandensein eines Halbleiterwafers 2 aus einer Messstrahlunterbrechung ergibt, bestimmt sich die vertikale Position aus den über den Encoder am Vertikalantrieb 10 abgenommenen Messergebnissen (Position) zum Zeitpunkt der Strahlunterbrechung und der Strahlfreigabe. Die sich ergebenden Positionswerte sind im Unterschied zu feststehenden optischen Systemen sofort weiterverarbeitbar und können z.B. an ein Handhabungssystem übergeben werden.

Da die Dicke der Halbleiterwafer 2 in definierten Grenzen liegt, lässt sich aus den ermittelten Differenzen zweier Messwerte auch bestimmen, ob eine Doppelbelegung eines Faches oder eine Schräglage eines Halbleiterwafers 2 vorliegt.
Die ermittelten Daten werden der Ansteuer- und Auswerteelektronik zugeführt, dort ausgewertet und als gespeicherte Ergebnisse an einem nichtdargestellten Monitor zur Anzeige gebracht.

Nachdem der Messvorgang abgeschlossen ist, wird der Sensorkopf 13 in die tiefstmögliche Rückschwenkposition gefahren, dort um 90° um die Schwenkachse S-S zurückund damit aus der Öffnung 4 geschwenkt und anschließend in die Parkposition P abgesenkt.'

Der Vorteil der erfindungsgemäßen Einrichtung zeigt sich auch darin, dass eine am oberen Rand der Öffnung 4 liegende Zwischenposition eingenommen werden kann, von der aus auch Zwischendurchmessungen, soweit erforderlich, möglich sind.
Zur Optimierung der zeitlichen Abläufe sind auch alternierende Bewegungsabläufe möglich. Der Sensor wird dann in einer unteren Position eingeschwenkt, fährt eine untere Startposition an und ermittelt die Messwerte während der Bewegung zu einer oberen Endposition. In dieser oberen Endposition wird der Sensorbogen zurückgeschwenkt und in einer Ruheposition oberhalb der Öffnung positioniert. Die anschließende Messung erfolgt dann in umgekehrter Reihenfolge. Durch diesen Ablauf können die Leerlaufbewegungen reduziert werden.

## Patentansprüche

1. Einrichtung zur Detektion von übereinander mit einem bestimmten Abstand angeordneten Substraten an einer Öffnung eines Wandelementes mit einem Verschluss für die Öffnung, der durch einen unterhalb der Öffnung positionierten Antrieb in wenigsten zwei unterschiedlichen Richtungen relativ zu dem Wandelement verstellbar ist und mit einer Sende- und Empfangseinrichtung zum Aussenden und Empfangen eines horizontal gerichteten Messstrahls, **dadurch gekennzeichnet, dass** die Sende- und Empfangseinrichtung (11) aus einem, an dem Wandelement (1) befestigten Vertikalantrieb (10) und einem, zwischen einer unteren und einer oberen Position durch den Vertikalantrieb (10) verstellbaren Sensorkopf (13) besteht, der zum Einschwenken in die Öffnung (4) an dem Vertikalantrieb (10) drehbar gelagert ist.

2. Einrichtung nach Anspruch 1, **dadurch gekennzeichnet, dass** der Vertikalantrieb (10) unterhalb der Öffnung (4) und außerhalb des Bewegungsbereiches des Verschlusses (6) an dem Wandelement (1) befestigt ist.

3. Einrichtung nach Anspruch 2, **dadurch gekennzeichnet, dass** der Vertikalantrieb (10) den Sensorkopf (13) an einem Schwenkkopf (18) mit horizontal gerichteter Schwenkachse (S-S) trägt, der an einem vertikal ausfahrbaren Arm (12) befestigt ist.

4. Einrichtung nach Anspruch 3, **dadurch gekennzeichnet, dass** die Schwenkachse (S-S) durch eine Hohlwelle (19) verläuft, auf der der Sensorkopf (13) aufgesetzt ist und die zwischen zwei Endlagenpositionen verdrehbar ist.

5. Einrichtung nach einem der Ansprüche 1 bis 4, **dadurch gekennzeichnet, dass** der Sensorkopf (13) als Gabellichtschranke ausgebildet ist, bei der an einem ersten Gabelende (25) ein Sender (26) zum Aussenden eines entlang eines Messstrahlenganges (M-M) auf das andere Gabelende (28) gerichteten Messstrahls angebracht und an dem anderen Gabelende (28) eine Strahlumlenkeinrichtung vorgesehen ist, von der aus eine daran angekoppelte Lichtleitfaser (31) außerhalb des Messstrahlenganges (M-M) mittels einer Optik lichtdicht an einen Empfänger (32) an dem ersten Gabelende (25) geführt ist.

6. Einrichtung nach Anspruch 5, **dadurch gekennzeichnet, dass** die Gabellichtschranke um eine horizontal gerichtete Schwenkachse (S-S) drehbar gelagert ist, die parallel und beabstandet zum Messstrahlengang (MM) verläuft, so dass die Gabelenden (25, 28) bei einer Schwenkung um die Schwenkachse (S-S) durch die Öffnung (4) in dem Wandelement (1) hindurchtreten.

7. Einrichtung nach Anspruch 6, **dadurch gekennzeichnet, dass** der Sender (26) als Laser ausgebildet ist.

8. Einrichtung nach einem der Ansprüche 1 bis 7, **dadurch gekennzeichnet, dass** die Sende- und Empfangseinrichtung (11) mit einer eigenen Ansteuerund Auswerteelektronik versehen ist, die an ein Bussystem einer zentralen Logiksteuerung angeschlossen ist.

9. Einrichtung nach Anspruch 8, **dadurch gekennzeichnet, dass** der Vertikalantrieb (10) als Motor-Spindel-Kombination aufgebaut ist, die zum Erkennen der vertikalen Positionen einen Encoder aufweist, der mit der Ansteuer- und Auswerteelektronik der Sende- und Empfangseinrichtung (11) verbunden ist, wodurch die aus dem Empfänger (32) erhaltenen Messsignale den ermittelten vertikalen Positionen zuzuordnen sind.

10. Einrichtung nach einem der Ansprüche 1 bis 4, **dadurch gekennzeichnet, dass** der Sensorkopf als Reflexmesseinrichtung ausgebildet ist, bei der Sender und Empfänger am Sensorkopf benachbart zueinander angeordnet sind.
